(19) Europäisches Patentamt / European Patent Office / Office européen des brevets

(11) **EP 3 863 102 B1**

(12) **EUROPEAN PATENT SPECIFICATION**

(45) Date of publication and mention of the grant of the patent:
**26.07.2023 Bulletin 2023/30**

(21) Application number: **18838195.8**

(22) Date of filing: **01.11.2018**

(51) International Patent Classification (IPC):
*H01M 10/42* (2006.01)    *H01M 10/48* (2006.01)
*H02J 7/00* (2006.01)    *G01R 31/36* (2020.01)
*G01R 31/387* (2019.01)    *G01R 31/374* (2019.01)
*G01R 31/385* (2019.01)    *G01R 31/378* (2019.01)

(52) Cooperative Patent Classification (CPC):
**G01R 31/374; G01R 31/3865; G01R 31/387; H01M 10/425; H01M 10/48;** G01R 31/378; Y02E 60/10

(86) International application number:
**PCT/CN2018/113280**

(87) International publication number:
**WO 2019/020133 (31.01.2019 Gazette 2019/05)**

(54) **TEMPERATURE COMPENSATION SYSTEM AND METHOD FOR LITHIUM BATTERY CAPACITY MEASUREMENT, AND STORAGE MEDIUM**

SYSTEM UND VERFAHREN ZUR TEMPERATURKOMPENSATION FÜR LITHIUMBATTERIEKAPAZITÄTSMESSUNG UND SPEICHERMEDIUM

SYSTÈME ET PROCÉDÉ DE COMPENSATION DE TEMPÉRATURE POUR MESURE DE CAPACITÉ DE BATTERIE AU LITHIUM, ET SUPPORT D'ENREGISTREMENT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**11.08.2021 Bulletin 2021/32**

(73) Proprietor: **Guangdong HYNN Technologies Co., Ltd.**
**Dongguan, Guangdong 523000 (CN)**

(72) Inventors:
• **ZHAO, Shaohua**
  **Shenzhen**
  **Guangdong 523000 (CN)**
• **WANG, Shoumo**
  **Shenzhen**
  **Guangdong 523000 (CN)**
• **FENG, Yingwei**
  **Shenzhen**
  **Guangdong 523000 (CN)**

(74) Representative: **Zaboliene, Reda**
**Metida**
**Business center Vertas**
**Gyneju str. 16**
**01109 Vilnius (LT)**

(56) References cited:
**CN-A- 106 207 284**    **CN-A- 108 037 460**
**CN-A- 108 321 444**    **JP-A- H06 281 709**
**US-A1- 2017 108 551**    **US-A1- 2018 306 868**

• LIU XIN ET AL: "Least squares support vector machine based lithium battery capacity prediction", 2014 INTERNATIONAL CONFERENCE ON MECHATRONICS AND CONTROL (ICMC), IEEE, 3 July 2014 (2014-07-03), pages 1148-1152, XP033213970, DOI: 10.1109/ICMC.2014.7231732 [retrieved on 2015-08-31]

- **KIM TAESIC ET AL: "A Rayleigh Quotient-Based Recursive Total-Least-Squares Online Maximum Capacity Estimation for Lithium-Ion Batteries", IEEE TRANSACTIONS ON ENERGY CONVERSION, IEEE SERVICE CENTER, PISCATAWAY, NJ, US, vol. 30, no. 3, 18 August 2015 (2015-08-18), pages 842-851, XP011666925, ISSN: 0885-8969, DOI: 10.1109/TEC.2015.2424673 [retrieved on 2015-08-18]**
- **Wang Linxia; Shang Suiju: "Capacity Grading Study of LiFeP04 Cells", Chinese Journal of Power Sources, vol. 34, no. 5, 31 May 2010 (2010-05-31), pages 458-459, XP009527232,**

## Description

## FIELD OF INVENTION

The present invention relates to the technical field of battery manufacturing technologies, in particular to a temperature compensation system, method and storage medium for lithium battery capacity measurement.

## BACKGROUND OF INVENTION

## Description of the Related Art

The capacity of a lithium battery is a key performance indicator that represents the ability of a lithium battery to store and release electric energy. In the production process of the lithium battery, various factors such as the ratio of materials used for making the positive and negative polarities, the thickness and uniformity of coating, the dryness and wetness of baking, the precharging process and environment, etc. will affect the capacity of the lithium battery. Therefore, the lithium battery production process generally includes a special formation process to measure the capacity of each lithium battery, and the measured capacity provides information for the subsequent sorting process and assembly process. In the formation process, the lithium battery is generally charged with constant current and constant voltage to a fully (100%) charged state first, and then discharged by constant current until the voltage reaches the cut-off voltage, the intensity of the discharge current and the discharge time are used to calculate the capacity. However, the inventor and applicant of this invention together with relevant literature of foreign and domestic researches discovered that the capacity of lithium battery is affected by ambient temperature significantly in the experiment procedure and production process. If the temperature is high, the activity of active matters of the lithium battery will be increased, and the capacity of the lithium battery will also be increased accordingly. On the other hand, if the temperature is low, the activity of active matters of the lithium battery will be decreased, and the capacity of the lithium battery will be decreased accordingly. In general, a nominal capacity of the lithium battery refers to the discharge capacity at room temperature (25 degrees Celsius). In the automated formation process, it is necessary to measure the nominal capacity of each lithium battery accurately. The process not just requires a control of the ambient temperature only, but also requires a control of the heat generated by the battery during the discharge process, and these controls need a high temperature control in the factory during the production process and increase the investment of equipment. CN108321444A discloses a grading compensation method, comprising testing capacity of system core under different temperature environments, and selectively discharging actual capacity or compensation capacity according to requirement of client.

CN108037460A discloses a real-time batch production lithium ion battery capacity evaluation method, comprising drawing full-capacity curve of lithium ion battery according to temperature of battery, and determining relationship between capacity and voltage of battery.

## SUMMARY OF THE INVENTION

Therefore, it is a primary objective of the present invention to overcome the technical problem of requiring a high temperature control in the factory during the production process of the lithium battery by providing a temperature compensation system and method for lithium battery capacity measurement.

To achieve the aforementioned technical problem, the present invention, as defined in independent claims 1 and 2, discloses the following technical solution:

A temperature compensation system for lithium battery capacity measurement includes an offline training and learning system, an online temperature compensation system, and a sampling inspection system; characterized in that the offline training and learning system is used for obtaining a capacity versus temperature characteristic curve of a certain type of lithium battery;

the online temperature compensation system is used for compensating a real-time temperature of the lithium battery of a certain type used and recorded and a testing capacity of the lithium battery of a certain type measured and obtained from the characteristic curve to obtain a room temperature compensation capacity of the lithium battery of a certain type under constant temperature; and

the sampling inspection system is used for performing a sampling inspection of the lithium battery of a certain type, and comparing the sampling capacity of the sampling battery measured under a constant room temperature environment with the room temperature compensation capacity obtained after the compensation to calculate an estimation error; if the estimation error exceeds an allowable threshold range, then the offline training and learning system will be prompted to perform a relearn.

In addition, the present invention further provides a temperature compensation method for lithium battery capacity measurement, and the method includes the steps of:

obtaining a capacity versus temperature characteristic curve of a lithium battery of a certain type by offline training and learning;

measuring and obtaining a real-time temperature and a testing capacity of the lithium battery of a certain type;

using the real-time temperature and the characteristic curve to compensate the testing capacity to obtain a room temperature compensation capacity of the lithium battery of a certain type under constant temperature; and

performing a sampling inspection of the lithium battery of a certain type, and comparing a sampling capacity of a sampling battery measured in a constant room temperature environment with the room temperature compensation capacity obtained after the compensation to calculate an estimation error; wherein, if the estimation error exceeds an allowable threshold range, then it will be prompted to perform the offline training and learning again to obtain a new characteristic curve.

In addition, the present invention further provides a computer readable storage medium that stores a computer program used together with a computing device, and the computer program being executed by a processor to realize the aforementioned temperature compensation method

Compared with the prior art, the present invention has the following advantageous effects:

The present invention obtains the temperature versus capacity characteristic curve by offline training and self-learning without requiring prior information related to raw materials, ratios, processes, etc., and thus simplifying the level of complexity. The system is close-looped, so that when a large deviation is found in the compensation result during the sampling inspection process, it shows that the properties of the raw materials have changed, and the system will prompt and indicate that the level of confidence of the data is low, and it is necessary to repeat the offline training and learning, so that the error correction mechanism of the sampling inspection can prevent a too-large error getting into production. Therefore, the temperature compensation can be used to reduce the temperature control requirement for the production of lithium battery in a factory during the formation process.

## BRIEF DESCRIPTION OF THE DRAWINGS

The present invention will become clearer in light of the following detailed description of an illustrative embodiment of this invention described in connection with the drawings.

FIG. 1 is a schematic view showing the structure of a temperature compensation system for lithium battery capacity measurement of the present invention;
FIG. 2 is a flow chart of a temperature compensation method for lithium battery capacity measurement of the present invention;
FIG. 3 shows the training results of an application in accordance with an embodiment of the present invention; and
FIG. 4 shows the online temperature compensation results of an application in accordance with an embodiment of the present invention.

## DESCRIPTION OF THE PREFERRED EMBODIMENTS

Exemplary embodiments are illustrated in referenced figures of the drawings. It is intended that the embodiments and figures disclosed herein are to be considered illustrative rather than restrictive.

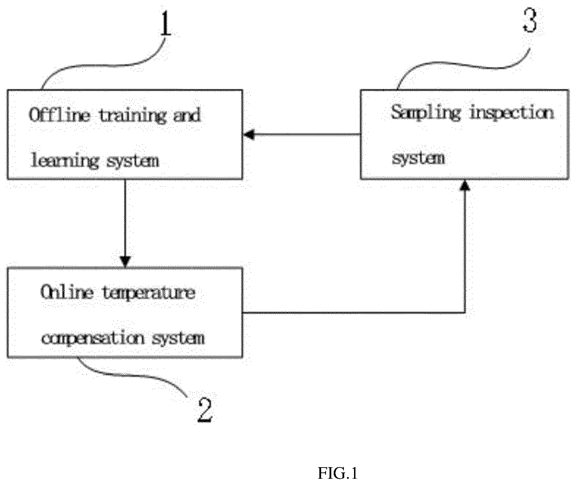

With reference to FIGS. 1 to 4 for the illustration and detailed description of an embodiment of the present invention, it should be emphasized that the following description is provided for the purpose of illustrating the present invention only, but not intended for limiting the scope and application of the invention.

In FIG. 1, a temperature compensation system for lithium battery capacity measurement is a smart capacity sorting system including an offline training and learning system 1, an online temperature compensation system 2 and a sampling inspection system 3.

The offline training and learning system 1 is used for obtaining a capacity versus temperature characteristic curve of a lithium battery of a certain type. The lithium battery of a certain type refers to a lithium battery of a certain model number in the production process, and its quantity depends on actual requirements. In order to ensure the accuracy of data, it is recommended to use more than 1000 pieces of the lithium batteries for training and learning.

The online temperature compensation system 2 is used for compensating a real-time temperature of the lithium battery of a certain type used and recorded and a testing capacity of the lithium battery of a certain type measured and obtained from the characteristic curve to obtain a room temperature compensation capacity of the lithium battery of a certain type under constant temperature

The sampling inspection system is used for performing a sampling inspection of the lithium battery of a certain type, and comparing the sampling capacity of the sampling battery measured under a constant room temperature environment with the room temperature compensation capacity obtained after the compensation to calculate an estimation error; if the estimation error exceeds an allowable threshold range, then the offline training and learning system will be prompted to perform a relearn. The quantity of the inspected batteries is a part of the total number of the lithium battery of a certain type, such as 1%, 2%, or 5%, depending on actual requirements.

The temperature compensation method for lithium battery capacity measurement in accordance with the present invention is described in details below.

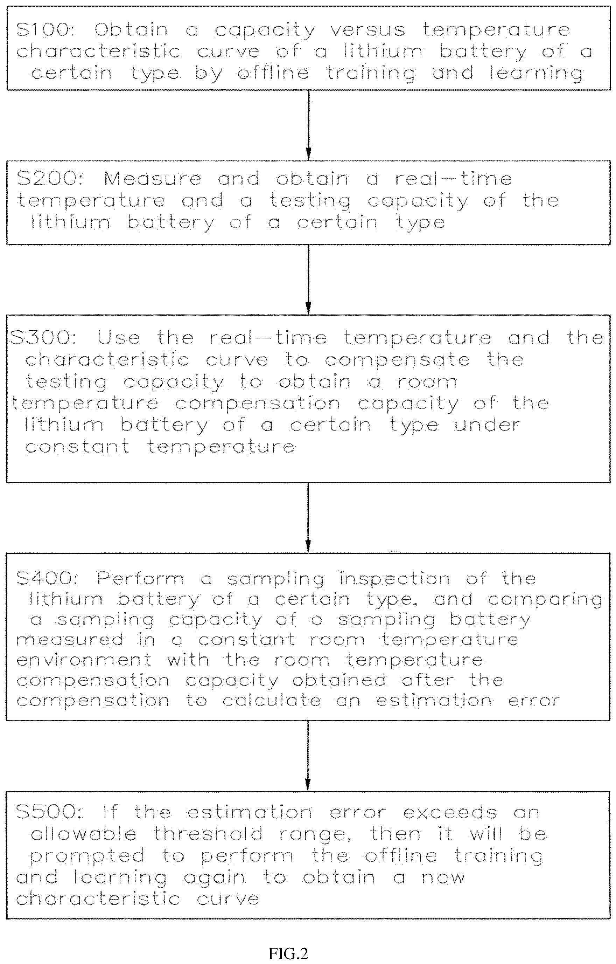

With reference to FIG. 2 for a temperature compensation method used for lithium battery capacity measurement in accordance with the present invention, the method includes the steps S100 to S500.

S100: Obtain a capacity versus temperature characteristic curve of a lithium battery of a certain type by offline training and learning. An offline training and learning system perform a capacity measurement of a batch of lithium batteries of a certain type at a discrete constant temperature point, and then performs a polynomial fitting of the measured data to obtain a capacity versus temperature characteristic curve of the lithium battery of a certain type, and finally inputs the characteristic curve into the online temperature compensation system.

S200: Measure and obtain a real-time temperature and a testing capacity of the lithium battery of a certain type. In the formation process, the online temperature compensation system instantly obtains and records a real-time temperature of the battery, and obtains a testing capacity of each battery.

S300: Use the real-time temperature and the characteristic curve to compensate the testing capacity to obtain a room temperature compensation capacity of the lithium battery of a certain type under constant temperature.

S400: Perform a sampling inspection of the lithium battery of a certain type, and compare a sampling capacity of a sampling battery measured in a constant room temperature environment with the room temperature compensation capacity obtained after the compensation to calculate an estimation error. For example, the constant room temperature environment can be a thermostat.

S500: If the estimation error exceeds an allowable threshold range, then it will be prompted to perform the offline training and learning again to obtain a new characteristic curve.

Based on the description above, the present invention obtains the temperature versus capacity characteristic curve by offline training and self-learning without requiring prior information related to raw materials, ratios, processes, etc., and thus simplifying the level of complexity. The system is close-looped, so that when a large deviation is found in the compensation result during the sampling inspection process, it shows that the properties of the raw materials have changed, and the system will prompt and indicate that the level of confidence of the data is low, and it is necessary to repeat the offline training and learning, so that the error correction mechanism of the sampling inspection can prevent a too-large error getting into production. Therefore, the temperature compensation can be used to reduce the temperature control requirement for the production of lithium battery in a factory during the formation process.

In the temperature compensation method for lithium battery capacity measurement in accordance with the present invention, the order of steps can be changed flexibly. For example, the step S200 can be carried out before the step of S100, and this invention is not limited to a particular order, as long as the same effect is achieved and it is not contradicting the scope of the invention set forth in the claims.

The present invention is further described below.

The step (S100) of obtaining the capacity versus temperature characteristic curve of the lithium battery of a certain type by offline training and learning includes the following steps:

Measure the capacity of each of the lithium batteries of a certain type for a selected quantity of the lithium battery of a certain type under constant temperature at a discrete temperature point.

Calculate an average capacity of the capacities of all lithium batteries of a certain type on the discrete temperature point.

Fit the obtained average capacity by a fitting algorithm to obtain the characteristic curve. For example, the fitting is carried out by the least square method.

The step S100 specifically includes the steps S110 to S170.

S110: Select and Put N pieces of the lithium battery of a certain type waiting to be learned in a constant temperature environment. Wherein, it is recommended that N is greater than 1000.

S120: Set a plurality of discrete temperature points with an interval $\Delta T$ apart from one another within a temperature range [Tmin, Tmax], wherein Tmin and Tmax are the minimum temperature and maximum temperature that can be reached in an actual production environment respectively, $\Delta T$ is the discrete distance of the discrete temperature points, and the value of $\Delta T$ depends on the difference between Tmin and Tmax and the degree of dispersion of temperature

S130: Obtain a temperature $T_n^i$ and a charge and discharge capacity $c_n^i = \int_0^{t_n} I_n^i \, dt$ of a housing surface or a tab of each of the lithium batteries of a certain type on the discrete temperature point, wherein $c_n^i$ is the testing capacity of the battery n at the ith discrete temperature point, $t_n$ is the charge or discharge time, and $I_n^i$ is the charge or discharge current at the ith discrete temperature point of the battery n

S140: Quantify $T_n^i$ into the discrete temperature points by using $\Delta T$ as an increment, and recording the testing capacity at the discrete temperature point and the discrete temperature point $c_n^i$ of N pieces of batteries. Wherein, $\hat{T}^m$ represents the discrete temperature point after the quantification, $T_n^i$ is the temperature of a housing surface or a tab of each pieces of the lithium batteries of a certain type, which is an analog quantity, so that it is necessary to quantify the analog quantity into a digital quantity. At the discrete temperature point, $T_n^i$ is not necessarily equal to the discrete temperature point. For example, the set discrete temperature point is 37 degrees Celsius, but the corresponding $T_n^i$ is 36.9 degrees Celsius, and thus it is necessary quantify $T_n^i$ into 37 degrees Celsius.

S150: Repeat the steps S130 and S140, until all of the testing capacities $c_n^i$ of the lithium batteries of a certain type at the discrete temperature points are measured.

S160: Calculate an average capacity $\bar{c}^i = \frac{\sum_{m=1}^{M} c_m^i}{M}$ of all batteries at the ith discrete temperature point $\hat{T}^i$ after the quantification, wherein M is the quantity of all batteries at the ith discrete temperature point $\hat{T}^i$, and m is the mth battery;

S 170: Use a fitting algorithm to fit the average capacity $\bar{c}^i$ to obtain the continuous characteristic curve, and *Cr* is the continuous characteristic curve.

The invention is further elaborated below.

The step (S200) of measuring and obtaining a real-time temperature and a testing capacity of the lithium battery of a certain type includes the steps S210 and S220.

S210: Perform a charge and discharge test of each battery m in a formation process, and measure and record the charge or discharge time $t_m$, the charge or discharge current $I_m$, and the real-time temperature Tm of the battery.

S210: Calculate a testing capacity $c_m = \int_0^{t_m} I_m \, dt$ of the battery m, wherein $c_m$ is the testing capacity of the battery m.

The present invention is further elaborated below.

The step (S300) of using the real-time temperature and the characteristic curve to compensate the testing capacity to obtain a room temperature compensation capacity of the lithium battery of a certain type under constant temperature further includes the steps S310 to S330.

S310: Calculate a reference capacity $\bar{c}_m$ = $Cr(T_m)$ according to the characteristic curve *Cr* and the real-time temperature Tm.

S320: Calculate the difference $\Delta_m = \bar{c}_m - c_m$ between the reference capacity and the testing capacity.

S330: Calculate the room temperature compensation capacity $\hat{c}_m(T_r) = Cr(T_r) + \Delta_m$, $Cr(T_r)$ at a specified temperature $T_r$ after the compensation, which is the capacity calculated and obtained according to the characteristic curve *Cr* and the specified temperature $T_r$.

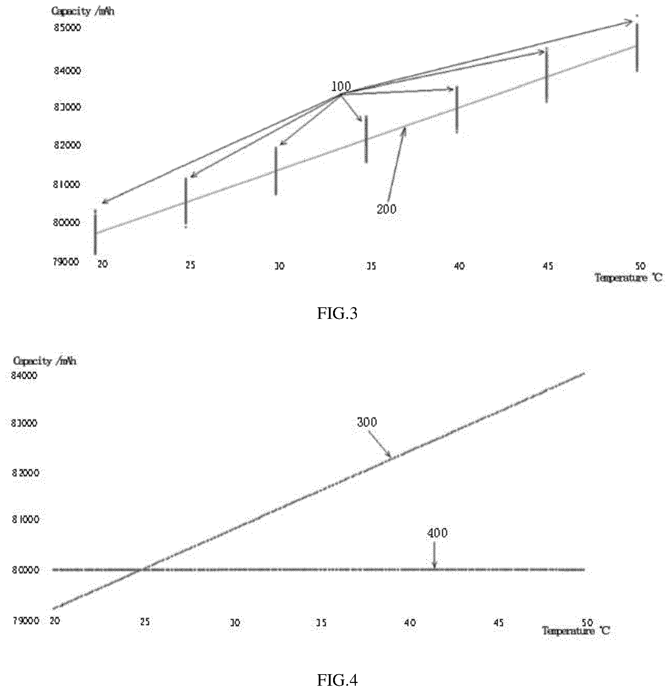

The present invention is described together with an application at a production site. In the production process of lithium batteries of a certain type of 80 amp, the offline training and learning system 1 selects and puts 5000 pieces of batteries into a constant temperature environment. Within the range from 20 to 50 degrees Celsius, an increment of 5 degrees Celsius is used as an interval to set the temperature of the constant temperature device point by point, and these points are the discrete temperature points. According to the Steps S130 to S170, a temperature versus capacity characteristic curve of the battery of that model number is trained and learned, and the training result is shown in FIG. 3, wherein the numeral 100 represents the capacity distribution of the discrete temperature points, the numeral 200 represents each discrete temperature point of the characteristic curve distributed near the center of the capacity of the battery. After an average capacity of each discrete temperature point is calculated and obtained, the average capacity of the temperature points is fitted to obtain a temperature versus capacity characteristic curve. The online temperature compensation result is shown in FIG. 4, wherein the numeral 300 represents the capacity before compensation, and the numeral 400 represents the capacity after compensation. It can be seen that the temperature compensation effectively suppresses the impact of the temperature on capacity measurement, and reduces the temperature control requirement for the production of the lithium battery in a factory during the formation process, and the error of the sampling inspection is less than 0.1%.

In addition, the present invention also provides a computer readable storage medium for storing a computer program used in a computing device, and the computer program is executed by a processor to realize the aforementioned temperature compensation method.

While the invention has been described by means of specific embodiments, numerous modifications and variations could be made thereto by those skilled in the art without departing from the scope of the invention set forth in the claims.

**Claims**

1.  A temperature compensation system for lithium battery capacity measurement, wherein

    the system comprises an offline training and learning system (1), an online temperature compensation system (2), and a sampling inspection system (3);
    the offline training and learning system (1) is used for obtaining a capacity versus temperature characteristic curve of a certain type of lithium battery; the online temperature compensation system (2) is used for compensating a real-time temperature of the lithium battery of a certain type used and recorded and an testing capacity of the lithium battery of a certain type measured and obtained from the characteristic curve to obtain a room temperature compensation capacity of the lithium battery of a certain type under constant temperature;
    the sampling inspection system (3) is used for performing a sampling inspection of the lithium battery of a certain type, and comparing the sampling capacity of the sampling battery measured under a constant room temperature environment with the room temperature compensation capacity obtained after the compensation to calculate an estimation error; if the estimation error exceeds an allowable threshold range, then the offline training and learning system (1) will be prompted to perform a relearn.

2. A temperature compensation method for lithium battery capacity measurement, wherein the method comprises the steps of:

obtaining (S100) a capacity versus temperature characteristic curve of a lithium battery of a certain type by offline training and learning;
measuring and obtaining (S200) a real-time temperature and a testing capacity of the lithium battery of a certain type;
using (S300) the real-time temperature and the characteristic curve to compensate the testing capacity to obtain a room temperature compensation capacity of the lithium battery of a certain type under constant temperature; and
performing a sampling inspection of the lithium battery of a certain type, and comparing a sampling (S400) capacity of a sampling battery measured in a constant room temperature environment with the room temperature compensation capacity obtained after the compensation to calculate an estimation error;
wherein if the estimation error exceeds an allowable threshold range, then it will be prompted (S500) to perform the offline training and learning again to obtain
a new characteristic curve.

3. The temperature compensation method of claim 2, wherein the step of obtaining the capacity versus temperature characteristic curve of the lithium battery of a certain type by offline training and learning further comprises the steps of:

measuring the capacity of each of the lithium batteries of a certain type for a selected quantity of the lithium battery of a certain type under constant temperature at a discrete temperature point;
calculating an average capacity of the capacities of all lithium batteries of a certain type on the discrete temperature point; and
fitting the obtained average capacity by a fitting algorithm to obtain the characteristic curve.

4. The temperature compensation method of claim 2, wherein the step of obtaining the capacity versus temperature characteristic curve of the lithium battery of a certain type by offline training and learning further comprises the steps of :

selecting and putting N pieces of the lithium battery of a certain type waiting to be learned in a constant temperature environment;
setting a plurality of discrete temperature points with an interval $\Delta T$ apart from one another within a temperature range [Tmin, Tmax], wherein Tmin and Tmax are the minimum temperature and maximum temperature that can be reached in an actual production environment respectively, $\Delta T$ is the discrete distance of the discrete temperature points, and the value of $\Delta T$ depends on the difference between Tmin and Tmax and the degree of dispersion of temperature;
obtaining the temperature $T_n^i$ and charge and discharge capacity
$$c_n^i = \int_0^{t_n} I_n^i \, dt$$ of a housing surface or a tab of each of the lithium batteries of a certain type on the discrete temperature point, wherein $c_n^i$ is the testing capacity of the battery n at the $i^{th}$ discrete temperature point, $t_n$ is the charge or discharge time , $I_n^i$ is the charge or discharge current at the $i^{th}$ discrete temperature point of the battery n;
quantifying $T_n^i$ into the discrete temperature points by using $\Delta T$ as an increment, and recording the testing capacity at the discrete temperature point and the discrete temperature point $c_n^i$ of N pieces of batteries;
repeating the foregoing two steps, until all of the testing capacities $c_n^i$ of the lithium batteries of a certain type at the discrete temperature points are measured;
calculating an average capacity
$$\bar{c}^i = \frac{\sum_{m=1}^M c_m^i}{M}$$ of all batteries at the $i^{th}$ discrete temperature point $\hat{T}^i$ after the quantification, wherein M is the quantity of all batteries at the $i^{th}$ discrete temperature point $\hat{T}^i$, and m is the $m^{th}$ battery; and
using a fitting algorithm to fit the average capacity $\bar{c}^i$ to obtain the continuous characteristic curve, and $Cr$ is the continuous characteristic curve.

5. The temperature compensation method of claim 2, wherein the step of measuring and obtaining the real-time temperature and the testing capacity of the lithium battery of a certain type further comprises the steps of:

performing a charge and discharge test of each battery m in a formation process, and measuring and recording the charge or discharge time $t_m$, the charge or discharge current $I_m$, the real-time temperature Tm of the battery; and

calculating a testing capacity $c_m = \int_0^{t_m} I_m$ dt of the battery m, wherein $c_m$ is the testing capacity of the battery m.

6. The temperature compensation method of claim 5, wherein the step of using the real-time temperature and the characteristic curve to compensate the testing capacity to obtain a room temperature compensation capacity of the lithium battery of a certain type under constant temperature further comprises the steps of:

calculating a reference capacity $\overline{c}_m = Cr(T_m)$ according to the characteristic curve $Cr$ and the real-time temperature Tm;
calculating the difference between the reference capacity and the testing capacity $\Delta_m = \overline{c}_m - c_m$;
calculating the room temperature compensation capacity $\hat{c}_m(T_r) = Cr(T_r) + \Delta_m$ at a specified temperature $T_r$ after the compensation,
wherein $Cr(T_r)$ is the capacity obtained and calculated according to the characteristic curve $Cr$ and the specified temperature $T_r$.

7. A computer readable storage medium, for storing a computer program used together with a computing device, and the computer program being executed by a processor to realize the temperature compensation method as claimed in any one of the claims 2 to 6.

**Patentansprüche**

1. Temperaturkompensationssystem zur Messung der Kapazität von Lithiumbatterien, wobei das System ein Offline-Trainings- und Lernsystem (1), ein Online-Temperaturkompensationssystem (2) und ein Stichprobenprüfungssystem (3) umfasst; wobei

das Offline-Trainings- und Lernsystem (1) wird verwendet, um eine Kapazitäts-Temperatur-Kennlinie eines bestimmten Typs von Lithiumbatterien zu erhalten;
das Online-Temperaturkompensationssystem (2) wird verwendet, um eine Echtzeittemperatur der verwendeten und aufgezeichneten Lithiumbatterie eines bestimmten Typs zu kompensieren sowie um eine Testkapazität der Lithiumbatterie eines bestimmten Typs aus der Kennlinie zu messen und zu erhalten, um eine Raumtemperaturkompensationskapazität der Lithiumbatterie eines bestimmten Typs bei konstanter Temperatur zu erhalten;
das Stichprobenprüfungssystem (3) wird verwendet, um eine Stichprobenprüfung der Lithiumbatterie eines bestimmten Typs durchzuführen und die in einer Umgebung mit konstanter Raumtemperatur gemessene Stichprobenkapazität der Stichprobenbatterie mit der nach der Kompensation erhaltenen Raumtemperaturkompensationskapazität zu vergleichen, um einen Bewertungsfehler zu berechnen; wenn der Bewertungsfehler einen zulässigen Schwellenwertbereich überschreitet, wird das Offline-Trainings- und Lernsystem (1) aufgefordert, einen Neulernvorgang durchzuführen.

2. Temperaturkompensationsverfahren zur Messung der Kapazität von Lithiumbatterien,
wobei das Verfahren die folgenden Schritte umfasst:

Ermittlung (S100) einer Kapazitäts-Temperatur-Kennlinie einer Lithiumbatterie eines bestimmten Typs durch Offline-Training und -Lernen;
Messen und Ermittlung (S200) einer Echtzeittemperatur und einer Testkapazität der Lithiumbatterie eines bestimmten Typs;
Verwendung (S300) der Echtzeittemperatur und der Kennlinie zur Kompensation der Testkapazität, um eine Raumtemperaturkompensationskapazität der Lithiumbatterie eines bestimmten Typs bei konstanter Temperatur zu erhalten; und
Durchführung einer Stichprobenprüfung der Lithiumbatterie eines bestimmten Typs und Vergleich einer in einer Umgebung mit konstanter Raumtemperatur gemessenen Stichprobenkapazität (S400) einer Stichprobenbatterie mit der nach der Kompensation erhaltenen Raumtemperaturkompensationskapazität, um einen Bewertungsfehler zu berechnen;
wobei, wenn der Bewertungsfehler einen zulässigen Schwellenwertbereich überschreitet, eine erneute Durchführung des Offline-Trainings und -Lernens veranlasst wird (S500), um eine neue Kennlinie zu erhalten.

3. Temperaturkompensationsverfahren nach Anspruch 2, wobei der Schritt der Ermittlung der Kapazitäts-Temperatur-Kennlinie der Lithiumbatterie eines bestimmten Typs durch Offline-Training und -Lernen weiterhin die folgenden Schritte umfasst:

Messen der Kapazität jeder Lithiumbatterie eines bestimmten Typs der ausgewählten Menge der Lithiumbatterien eines bestimmten Typs bei konstanter Temperatur an einem diskreten Temperaturpunkt;

Berechnung einer durchschnittlichen Kapazität der Kapazitäten aller Lithiumbatterien eines bestimmten Typs am diskreten Temperaturpunkt; und

Anpassung der erhaltenen durchschnittlichen Kapazität durch einen Anpassungsalgorithmus, um die Kennlinie zu erhalten.

4. Temperaturkompensationsverfahren nach Anspruch 2, wobei der Schritt der Ermittlung der Kapazitäts-Temperatur-Kennlinie der Lithiumbatterie eines bestimmten Typs durch Offline-Training und -Lernen weiterhin die folgenden Schritte umfasst:

Auswahl und Platzierung von N Stücken der Lithiumbatterie eines bestimmten Typs, die darauf warten, in einer Umgebung mit konstanter Temperatur erlernt zu werden;

Festlegen mehrerer diskreter Temperaturpunkte mit einem Abstand $\Delta T$ voneinander innerhalb eines Temperaturbereichs [Tmin, Tmax], wobei Tmin und Tmax die minimale und maximale Temperaturen sind, die in einer tatsächlichen Produktionsumgebung erreicht werden können, $\Delta T$ die diskreter Abstand der diskreten Temperaturpunkte ist, und der Wert von $\Delta T$ hängt von der Differenz zwischen Tmin und Tmax und dem Grad der Temperaturstreuung ab;

Ermittlung der Temperatur $T_n^i$ und der Lade- und Entladekapazität $c_n^i = \int_0^{t_n} I_n^i \, dt$ der Gehäuseoberfläche oder des Anschlüsses jeder der Lithiumbatterien eines bestimmten Typs am diskreten Temperaturpunkt, wobei $c_n^i$ die Testkapazität der Batterie n am i-ten diskreten Temperaturpunkt ist, $t_n$ die Lade- oder Entladezeit ist, $I_n^i$ der Lade- oder Entladestrom am i-ten diskreten Temperaturpunkt der Batterie n ist;

Quantifizierung von $T_n^i$ in den diskreten Temperaturpunkten unter Verwendung von $\Delta T$ als Inkrement, und Aufzeichnung der Testkapazität am diskreten Temperaturpunkt und am diskreten Temperaturpunkt $c_n^i$ von N Batteriestücken;

Wiederholung der beiden vorhergehenden Schritte, bis alle Testkapazitäten $c_n^i$ der Lithiumbatterien eines bestimmten Typs an den diskreten Temperaturpunkten gemessen sind;

Berechnung einer durchschnittlichen Kapazität

$$c^{-i} = \frac{\sum_{m=1}^M c_m^i}{M}$$

aller Batterien am i-ten diskreten Temperaturpunkt $T^i$ nach der Quantifizierung, wobei M die Menge aller Batterien am i-ten diskreten Temperaturpunkt $T^i$ ist, und m die m-te Batterie ist; und Verwendung eines Anpassungsalgorithmus zur Anpassung der durchschnittlichen Kapazität $c^i$ um die kontinuierliche Kennlinie zu erhalten, und $Cr$ die kontinuierliche Kennlinie ist.

5. Temperaturkompensationsverfahren nach Anspruch 2, wobei der Schritt des Messens und der Ermittlung der Echtzeittemperatur und der Testkapazität der Lithiumbatterie eines bestimmten Typs ferner die folgenden Schritte umfasst:

Durchführung einer Lade- und Entladeprüfung jeder Batterie m in einem Formationsprozess und Messen und Aufzeichnung der Lade- oder Entladezeit $t_m$, des Lade- oder Entladestroms $I_m$ und der Echtzeittemperatur Tm der Batterie; und

Berechnung einer Testkapazität $c_m = \int_0^{t_m} I_m \, dt$ der Batterie m, wobei $C_m$ die Testkapazität der Batterie m ist.

6. Temperaturkompensationsverfahren nach Anspruch 5, wobei der Schritt der Verwendung der Echtzeittemperatur und der Kennlinie zur Kompensation der Testkapazität, um eine Raumtemperaturkompensationskapazität der Lithiumbatterie eines bestimmten Typs unter konstanter Temperatur zu erhalten, weiterhin die folgenden Schritte umfasst:

Berechnung einer Referenzkapazität $\bar{c}_m = Cr(T_m)$ gemäß der Kennlinie Cr und der Echtzeittemperatur Tm;

Berechnung der Differenz zwischen der Referenzkapazität und der Testkapazität $\Delta m = \bar{c}_m - c_m$;

Berechnung der Raumtemperaturkompensationskapazität $\hat{c}_m(T_r) = Cr(T_r) + \Delta_m$ bei einer vorgegebenen Temperatur $T_r$ nach der Kompensation, wobei $Cr(T_r)$ die anhand der Kennlinie $Cr$ und der vorgegebenen Temperatur $T_r$ ermittelte und berechnete Kapazität ist.

7. Ein computerlesbares Speichermedium zum Speichern eines Computerprogramms, das zusammen mit einem Computergerät verwendet wird, wobei das Computerprogramm von einem Prozessor ausgeführt wird, um das Temperaturkompensationsverfahren nach einem der Ansprüche 2 bis 6 zu realisieren.

## Revendications

1. Système de compensation de température pour mesurer la capacité d'une batterie au lithium, dans lequel le système comprend un système de formation et d'apprentissage hors ligne (1), un système de compensation de température en ligne (2) et un système d'inspection par échantillonnage (3) ;

   le système de formation et d'apprentissage hors ligne (1) est utilisé pour obtenir une courbe caractéristique de capacité en fonction de la température d'un certain type de batterie au lithium ;
   le système de compensation de température en ligne (2) est utilisé pour compenser une température en temps réel de la batterie au lithium d'un certain type utilisée et enregistrée et une capacité de test de la batterie au lithium d'un certain type mesurée et obtenue à partir de la courbe caractéristique pour obtenir une capacité de compensation de température ambiante de la batterie au lithium d'un certain type à température constante ;
   le système d'inspection par échantillonnage (3) est utilisé pour effectuer une inspection par échantillonnage de la batterie au lithium d'un certain type, et comparer la capacité d'échantillonnage de la batterie d'échantillonnage mesurée dans un environnement à température ambiante constante avec la capacité de compensation de température ambiante obtenue après la compensation pour calculer une erreur d'estimation ; si l'erreur d'estimation dépasse une plage de seuil admissible, alors le système de formation et d'apprentissage hors ligne (1) sera invité à effectuer un réapprentissage.

2. Procédé de compensation de température pour la mesure de la capacité d'une batterie au lithium, dans lequel le procédé comprend les étapes consistant à :

   obtenir (S100) une courbe caractéristique de capacité en fonction de la température d'une batterie au lithium d'un certain type par formation et apprentissage hors ligne ;
   mesurer et obtenir (S200) une température en temps réel et une capacité de test de la batterie au lithium d'un certain type ;
   utiliser (S300) la température en temps réel et la courbe caractéristique pour compenser la capacité de test à obtenir une capacité de compensation de température ambiante de la batterie au lithium d'un certain type à température constante ; et
   effectuer une inspection par échantillonnage de la batterie au lithium d'un certain type, et comparer une capacité d'échantillonnage (S400) d'une batterie d'échantillonnage mesurée dans un environnement à température ambiante constante

   avec la capacité de compensation de température ambiante obtenue après la compensation pour calculer une erreur d'estimation ;
   dans lequel si l'erreur d'estimation dépasse une plage de seuil admissible, alors il sera invité (S500) à effectuer de nouveau la formation et l'apprentissage hors ligne pour obtenir une nouvelle courbe caractéristique.

3. Procédé de compensation de température selon la revendication 2, dans laquelle l'étape d'obtention de la courbe caractéristique de capacité en fonction de la température de la batterie au lithium d'un certain type par formation et apprentissage hors ligne comprend en outre les étapes consistant à :

   mesurer la capacité de chacune des batteries au lithium d'un certain type pour une quantité sélectionnée de la batterie au lithium d'un certain type à température constante à un point de température discret ;
   calculer une capacité moyenne des capacités de toutes les batteries au lithium d'un certain type sur le point de température discret ; et
   ajuster la capacité moyenne obtenue par un algorithme d'ajustement pour obtenir la courbe caractéristique.

4. Procédé de compensation de température selon la revendication 2, dans laquelle l'étape d'obtention de la courbe caractéristique de capacité en fonction de la température de la batterie au lithium d'un certain type par formation et apprentissage hors ligne comprend en outre les étapes consistant à :

   sélectionner et placer N pièces de la batterie au lithium d'un certain type en attente d'apprentissage dans un environnement à température constante ;
   établir une pluralité de points de température discrets avec un intervalle ΔT les uns des autres dans une plage de température [Tmin, Tmax], où Tmin et Tmax sont respectivement la température minimale et la température maximale pouvant être atteintes dans un environnement de production réel, ΔT est la distance discrète des points de température discrets, et la valeur de ΔT dépend de la différence entre Tmin et Tmax et
   du degré de dispersion de température ;

   obtenir la température $T_n^i$ et la capacité de charge et de décharge

$$c_n^i = \int_0^{t_n} I_n^i \, dt$$

d'une surface de boîtier ou d'une languette de chacune des batteries au lithium d'un certain type sur le point de température discret, où $c_n^i$ est la capacité de test de la batterie n au ième point de température discret, tn est le temps de charge ou de décharge, In est le courant de charge ou de décharge au ième point de température discret de la batterie n ;

quantifier $T_n^i$ dans les points de température discrets en utilisant ∆T comme incrément, et enregistrer la capacité de test au point de température discret et au point de température discret $c_n^i$ de N pièces de batteries ;
répéter les deux étapes précédentes, jusqu'à ce que toutes les capacités $c_n^i$ de test des batteries au lithium d'un certain type aux points de température discrets soient mesurées ;
calculer une capacité moyenne

$$c^{-i} = \frac{\sum_{m=1}^{M} c_m^i}{M}$$

de toutes les batteries au ième point de température discrète $T^i$ après la quantification, où M est la quantité de toutes les batteries au ième point de température discret $T^i$ et m est la même batterie ; et utiliser un algorithme d'ajustement pour ajuster la capacité moyenne $c^{-i}$ afin d'obtenir la courbe caractéristique continue, et Cr est la courbe caractéristique continue.

5. Procédé de compensation de température selon la revendication 2, dans laquelle l'étape de mesure et d'obtention de la température en temps réel et de la capacité de test de la batterie au lithium d'un certain type comprend en outre les étapes consistant à : effectuer un test de charge et de décharge de chaque batterie m dans un processus de formation, et mesurer et enregistrer le temps de charge ou de décharge $t_m$, le courant de charge ou de décharge $I_m$, la température en temps réel Tm de la batterie ; et

calculer une capacité de test $c_m = \int_0^{t_m} I_m \, dt$ de la batterie m, où $c_m$ est la capacité de test de la batterie m.

6. Procédé de compensation de température selon la revendication 5, dans laquelle l'étape d'utilisation de la température en temps réel et de la courbe caractéristique pour compenser la capacité de test pour obtenir une capacité de compensation de température ambiante de la batterie au lithium d'un certain type à température constante comprend en outre les étapes de :

calculer une capacité de référence $\overline{c}_m = Cr(T_m)$ en fonction de la courbe Cr caractéristique et de la température en temps réel Tm ;
calculer la différence entre la capacité de référence et la capacité de test $\Delta_m = \overline{c}_m - c_m$ ; calculer la capacité $\hat{c}_m(T_r) = Cr(T_r) + \Delta_m$ de compensation de la température ambiante à une température $T_r$ spécifiée après la compensation, où $Cr(T_r)$ est la capacité obtenue et calculée selon la courbe de caractéristique Cr et la température spécifiée $T_r$

7. Support de stockage lisible par ordinateur, pour stocker un programme informatique utilisé avec un dispositif informatique, et le programme informatique étant exécuté par un processeur pour réaliser le procédé de compensation de température selon n'importe quelle des revendications 2 à 6.

1

3

| Offline training and learning system | ← | Sampling inspection system |

2

Online temperature compensation system

FIG.1

S100: Obtain a capacity versus temperature characteristic curve of a lithium battery of a certain type by offline training and learning

S200: Measure and obtain a real—time temperature and a testing capacity of the lithium battery of a certain type

S300: Use the real—time temperature and the characteristic curve to compensate the testing capacity to obtain a room temperature compensation capacity of the lithium battery of a certain type under constant temperature

S400: Perform a sampling inspection of the lithium battery of a certain type, and comparing a sampling capacity of a sampling battery measured in a constant room temperature environment with the room temperature compensation capacity obtained after the compensation to calculate an estimation error

S500: If the estimation error exceeds an allowable threshold range, then it will be prompted to perform the offline training and learning again to obtain a new characteristic curve

FIG.2

FIG.3

FIG.4

**REFERENCES CITED IN THE DESCRIPTION**

**Patent documents cited in the description**

- CN 108321444 A

- CN 108037460 A